Europäisches Patentamt

European Patent Office

Office européen des brevets

(11) Veröffentlichungsnummer: **0 387 672**
**A2**

## (12) EUROPÄISCHE PATENTANMELDUNG

(21) Anmeldenummer: **90104311.7**

(22) Anmeldetag: **07.03.90**

(51) Int. Cl.5: **H01L 21/00**

(30) Priorität: **16.03.89 DE 8903250 U**

(43) Veröffentlichungstag der Anmeldung:
**19.09.90 Patentblatt 90/38**

(84) Benannte Vertragsstaaten:
**CH DE FR GB IT LI**

(71) Anmelder: **Blaupunkt-Werke GmbH**
**Robert-Bosch-Strasse 200**
**D-3200 Hildesheim(DE)**

(72) Erfinder: **Günster, Holger**
**Hammersteinstrasse 47**
**D-3200 Hildesheim(DE)**

(74) Vertreter: **Eilers, Norbert, Dipl.-Phys.**
**Blaupunkt-Werke GmbH**
**Robert-Bosch-Strasse 200**
**D-3200 Hildesheim(DE)**

(54) **Aufnahme für eine Vorrichtung zum Drahtbonden von Halbleiterchips.**

(57) Bei einer Aufnahme (1) für eine Vorrichtung zum Drahtbonden von Halbleiterchips auf Isolierstoff-Folien weist die tischplattenförmig ausgebildete Aufnahme (1) in ihrer Arbeitsfläche (20) Bohrungen (7 bis 16) auf, die mit einem Anschluß (3) für eine atmosphärische Unterdruckleitung verbunden sind. Damit eine flexible Folie (18) fest und vibrationsfrei auf der Arbeitsfläche (20) gehalten werden kann, ist die Arbeitsfläche mit einer ringförmigen Vertiefung (6) versehen, die über Bohrungen (7 bis 10) mit dem Anschluß (3) für die atmosphärische Unterdruckleitung verbunden ist. Bei vorhandenem Unterdruck wird die flexible Folie (18) in die ringförmige Vertiefung (6) gezogen und damit so vorgespannt, daß sie in dem von der Vertiefung (6) umschlossenen Bereich fest auf der Arbeitsfläche (20) aufliegt .

Fig.1

EP 0 387 672 A2

Die Erfindung betrifft eine Aufnahme für eine Vorrichtung zum Drahtbonden von Haltleiterchips auf Leiterbahnen aufweisenden Isolierstoff-Folien, wobei die tischplattenförmig ausgebildete Aufnahme in ihrer Arbeitsfläche Aussparungen aufweist, die über Bohrungen mit einem Anschluß für eine atmosphärische Unterdruckleitung verbunden sind.

Derartige Aufnahmen dienen dazu, die elektrisch zu verbindenden Teile während des Bondens derart auf dem Aufnahmetisch der Bondvorrichtung zu fixieren, daß die zur Verbindung verwendeten Golddrähtchen mittels Ultraschallenergie mit den Anschlüssen des Halbleiterchips und den Goldpads der Leiterfolie verschweißt werden können.

Es ist bekannt, die Arbeitsflächen der Aufnahmen mit Bohrungen und parallel angeordneten Vertiefungen zu versehen, die mit einem Anschluß für eine atmosphärische Unterdruckleitung verbunden sind. Derartige Aufnahmen eignen sich gut für eine Fixierung von mit Halbleiterchips versehenen Keramiken. Sie sind jedoch für mit Halbleiterchips und Leiterbahnen versehene flexible Kunststoff-Folien wenig geeignet, da diese nicht ausreichend fest an derartig ausgestalteten Arbeitsflächen anlegbar sind und zudem infolge auftretender Luftströmungen zu Vibrationen neigen.

Der Erfindung liegt daher die Aufgabe zugrunde, eine Aufnahme für eine Vorrichtung zum Drahtbonden so zu gestalten, daß damit auf flexiblen Folien angeordnete Halbleiterchips gebondet werden können.

Diese Aufgabe wird erfindungsgemäß dadurch gelöst, daß die Arbeitsfläche der Aufnahme mindestens eine ringförmige Vertiefung aufweist, welche über Bohrungen mit dem Anschluß für die atmosphärische Unterdruckleitung verbunden ist und daß die Vertiefung derart ausgebildet ist, daß die flexible Folie bei vorhandenem Unterdruck in die ringförmige Vertiefung gezogen und damit so vorgespannt wird, daß sie in dem von der Vertiefung umschlossenen Bereich fest auf der Arbeitsfläche aufliegt.

Die mit der Erfindung erzielten Vorteile bestehen insbesondere darin, daß die Folie fest und sicher auf der Arbeitsfläche aufliegt und damit ein zuverlässiges Bonden ermöglicht. Zudem kann die Vorrichtung sowohl vertikal als auch horizontal betrieben werden. Dieses erweitert ihren Einsatz in den üblichen Bondvorrichtungen.

Vorteilhafte Ausgestaltungen der Aufnahme sind in den Unteransprüchen angegeben.

Ein Ausführungsbeispiel der Erfindung ist im Prinzip in der Zeichnung dargestellt und wird im folgenden näher beschrieben.

Es zeigen:

Figur 1 die Draufsicht und

Figur 2 eine geschnittene Seitenansicht einer Aufnahme für eine Bondvorrichtung

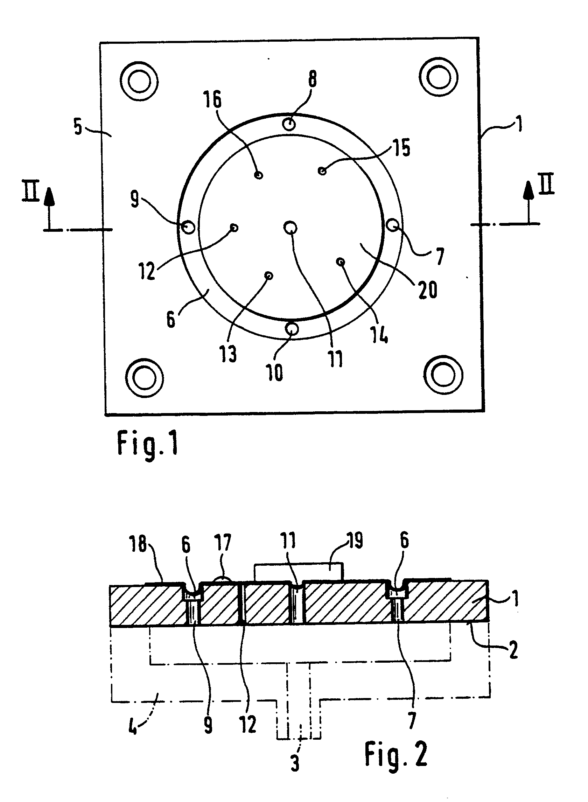

Die Aufnahme 1 besteht aus einer in der Draufsicht nach Figur 1 quadratisch ausgebildeten Metallplatte, welche mittels nicht dargestellter Schrauben mit ihrer Unterseite 2 luftdicht auf einem in Figur 2 angedeuteten, mit einem Unterdruckleitungsanschluß 3 versehenen geschlossenen Gehäuse 4 befestigt ist. Das Gehäuse 4 ist Teil einer an sich bekannten, nicht dargestellten Bondvorrichtung. Die tischplattenförmig ausgebildete Aufnahme 1 ist an ihrer Oberseite 5 mit einer kreisringförmigen Vertiefung 6 versehen, die vier in gleichen Winkelabständen angeordnete, zur Unterseite 2 der Aufnahme 1 durchgehende Bohrungen 7, 8, 9, 10 aufweist. In dem von der ringförmigen Vertiefung 6 umschlossenen Bereich der Aufnahme 1 sind weitere von der Oberseite 5 zur Unterseite 2 durchgehende Bohrungen 11 bis 16 vorgesehen, wobei eine mittig angeordnete Bohrung 11 einen größeren Durchmesser aufweist als die übrigen Bohrungen 12 bis 16.

Wird nun über den Schlauchanschluß 3 ein atmosphärischer Unterdruck von etwa -0,8 bar erzeugt, so wird eine mit Leiterbahnen und Goldpads 17 versehene flexible Isolierstoff-Folie 18, die mit einem aufgeklebten Halbleiterchip 19 versehen ist, gemäß Figur 2 in die ringförmige Vertiefung 6 gezogen. Dadurch wird die von der Vertiefung 6 umschlossene Fläche der Folie 18 vorgespannt, so daß sie sich unter Mitwirkung der weiteren Bohrungen 11 bis 16 fest an die als Arbeitsfläche 20 dienende Oberfläche der Aufnahme 1 anschmiegt. Nach dem Fixieren der Folie 18 kann das eigentliche Bonden erfolgen.

Es hat sich als besonders vorteilhaft herausgestellt, die unter dem Halbleiterchip vorgesehene Bohrung 11 mit einem Durchmesser von etwa 1,5 mm zu versehen und die weiteren, einen Durchmesser von 0,5 mm aufweisenden Bohrungen 12 bis 16 so zu plazieren, daß die Goldpads 17 zwischen der ringförmigen Vertiefung 6 und diesen Bohrungen angeordnet sind.

## Ansprüche

1. Aufnahme für eine Vorrichtung zum Drahtbonden von Halbleiterchips auf Leiterbahnen aufweisenden Isolierstoff-Folien, wobei die tischplattenförmig ausgebildete Aufnahme in ihrer Arbeitsfläche Aussparungen aufweist, die über Bohrungen mit einem Anschluß für eine atmosphärische Unterdruckleitung verbunden sind,
dadurch gekennzeichnet,
daß die Arbeitsfläche (20) der Aufnahme (1) mindestens eine ringförmige Vertiefung (6) aufweist, welche über Bohrungen (7 bis 10) mit dem Anschluß (3) für die atmosphärische Unterdruckleitung verbunden ist und daß die Vertiefung (6) derart ausgebildet ist, daß die flexible Folie (18) bei vorhandenem Unterdruck in die ringförmige Vertiefung (6) gezogen und damit so vorgespannt wird, daß sie in dem von der Vertiefung (6) umschlossenen Bereich fest auf der Arbeitsfläche (20) aufliegt.

2. Aufnahme nach Anspruch 1,
dadurch gekennzeichnet,
daß die von der kreisförmigen Vertiefung (6) umschlossene Arbeitsfläche (20) der Aufnahme (1) mindestens eine die Arbeitsfläche (20) mit der Unterdruckleitung (3) verbindende Bohrung (11 bis 16) aufweist.

3. Aufnahme nach Anspruch 1 oder Anspruch 2,
dadurch gekennzeichnet,
daß die kreisringförmige Vertiefung (6) den zu bondenden Halbleiterchip (19) und die dazugehörigen Goldpads (17) auf der Folie (18) umschließt.

4. Aufnahme nach Anspruch 2,
dadurch gekennzeichnet,
daß vorzugsweise dem Halbleiterchip (19) eine größere Bohrung (11) und den Goldpads (17) kleinere Bohrungen (12 bis 16) zugeordnet sind.

5. Aufnahme nach Anspruch 4,
dadurch gekennzeichnet,
daß die Durchmesser der zugeordneten Bohrungen (11 bis 16) für die Halbleiterchips (19) etwa 1,5 mm und für die Goldpads (17) etwa 0,5 mm betragen.

Fig.1

Fig. 2